# EUROPÄISCHE PATENTSCHRIFT

(11) **EP 0 584 896 B1**
(45) Veröffentlichungstag und Bekanntmachung des Hinweises auf die Patenterteilung: **04.09.1996**
(21) Anmeldenummer: 93250188.5
(22) Anmeldetag: 23.06.1993
(51) Int. Cl.: H02B 1/38, H05K 9/00

(54) **Schaltschrank mit Dichtungselementen zur Abdichtung einer Tür im geschlossenen Zustand**
Switchgear cabinet having sealing devices for sealing a door in its closed state
Armoire de commutation ayant des éléments d'étanchéité pour étancher une porte à état de fermeture

(30) Priorität: 26.08.1992 DE 4228427
(43) Veröffentlichungstag der Anmeldung: 02.03.1994
(73) Patentinhaber: SIEMENS AKTIENGESELLSCHAFT, 80333 München (DE)
(72) Erfinder: Blum, Richard, D-6057 Dietzenbach (DE); Groh, Hans-Michael, Dipl.-Ing., D-6452 Hainburg 2 (DE); Küster, Willi, D-6460 Gelnhausen (DE); Herr, Klaus-Jürgen, Dipl.-Ing., D-6464 Linsengericht 4 (DE)

(56) Entgegenhaltungen:
- EP-A- 0 176 619
- GB-A- 2 036 840
- US-A- 4 857 668

## Beschreibung

Die Erfindung betrifft einen Schaltschrank mit einer durch Rahmenteile gebildeten Frontfläche zur Auflage einer mit in Richtung der Frontfläche abgekanteten Randschenkeln versehenen Tür, wobei an der Tür zur Abdichtung im geschlossenen Zustand Dichtungselemente aus gummielastischem Material angebracht sind.

Ein Schaltschrank dieser Art ist beispielsweise durch die DE-A-39 20 353 bekannt geworden. Zur Halterung der Dichtungselemente sind die Randschenkel der Tür derart profiliert, daß eine Nut oder Rille zum Einlegen des Dichtungselementes gebildet wird. Es ist auch bekannt, eine solche Nut oder Rille dadurch zu bilden, daß die Tür glatt abgekantete Randschenkel erhält und daß an der Innenseite der Tür ein Rahmen befestigt wird, der parallel zu den Randschenkeln verlaufende Abkantungen aufweist. Dabei entsteht die Schwierigkeit, daß im Bereich der Scharniere der Tür eine spezielle Formgebung sowohl der Randschenkel mit ihrer Profilierung oder der zusätzlich verwendeten Rahmen erforderlich ist, damit die Dichtungselemente auch im Bereich der Scharniere in der gewünschten Weise auf der Frontfläche des Schaltschrankes aufliegen können.

Der Erfindung liegt hiervon ausgehend die Aufgabe zugrunde, bei einem Schaltschrank der eingangs genannten Art Profilierungen oder Halterahmen zur Aufnahme der Dichtungselemente zu vermeiden und zugleich im Scharnierbereich der Tür eine gute Dichtigkeit zu erzielen. Ergänzend wird eine Eignung einer solchen Dichtungsanordnung zur Schaffung eines gegen elektromagnetische Strahlung abgedichteten Schaltschrankes gefordert.

Diese Aufgabe wird gemäß der Erfindung dadurch gelöst, daß die Dichtungselemente einen zur Auflage auf der Frontfläche bestimmten hohl ausgebildeten Kopfsteg und anschließend an den Kopfsteg einen zur Anbringung an den Randschenkeln der Tür mittels einer selbstklebenden Haftschicht bestimmten Befestigungssteg besitzen, wobei der Kopfsteg mit einer Seitenfläche teilweise an dem Randschenkel anliegt und wobei der Befestigungssteg gegenüber der einen Seitenfläche des Kopfsteges um etwa die Dicke der Haftschicht zurückgesetzt angeordnet ist. Die Haftschicht kann bei der Herstellung der Dichtungselemente an diesen angebracht werden. Andererseits kann die Haftschicht an den Randschenkeln der Tür gesondert angebracht werden. In beiden Fällen genügt es zur Montage der Dichtungselemente, diese mit ihrem Befestigungssteg kräftig anzudrücken. Es sind somit spezielle Profilierungen der Randschenkel oder zusätzliche Rahmen entbehrlich, die mit dem Randschenkel zusammen eine Nut bilden. Da nur der Befestigungssteg an dem abgekanteten Randschenkel der Tür fest anliegt, kann der Kopfsteg seitlich gebogen und aufgrund der hohlen Ausbildung auch um ein gewisses Maß zusammengedrückt werden. Aufgrund dieser Merkmale ergibt sich eine relativ gute Anpassung des Dichtungselementes an die Oberfläche der Frontfläche des Schaltschrankes. Insbesondere ist das Dichtungselement auch in der Lage, im Bereich eines auf der Frontfläche aufliegenden Fußteiles eine Scharnieres die gewünschte Abdichtung zu bewirken.

Es ist bereits ein vorzugsweise für Abdichtungen an Fahrzeugkarosserien geeignetes Dichtungselement aus gummielastischem Material bekanntgeworden, das einen Befestigungssteg und einen hohlen Kopfsteg aufweist (GB 2 036 840 A). Der Befestigungssteg ist mittels einer selbstklebenden Haftschicht an einem Karosserieteil zu befestigen. Dabei sind der Kopfsteg und der Befestigungssteg miteinander in der Weise biegsam verbunden, daß der Kopfsteg eine an den Befestigungssteg angenäherte oder weiter entfernte Position einnehmen kann. Demgegenüber sieht die Erfindung eine Abstützung des Kopfsteges an einem Randschenkel der Tür vor. Da der Befestigungssteg mittels der selbstklebenden Haftschicht an dem Randsteg der Tür anliegt, kann das Dichtungselement ohne Unterbrechung am Umfang einer mit abgekanteten Randschenkeln versehenen Tür verlegt werden.

Während diejenigen Dichtungselemente oder Abschnitte derselben, die von den Scharnieren der Tür um ein gewisses Maß entfernt sind, beim Schließen der Tür im wesentlichen geradlinig und rechtwinklig auf die Frontfläche des Schaltschrankes auftreffen, unterliegen die näher zu den Scharnieren gelegenen Abschnitt der Dichtungselemente einer Beanspruchung durch gleitende Reibung. Diese kann nach einer weiteren Ausgestaltung der Erfindung dadurch wesentlich verringert werden, daß wenigstens das an der Scharnierseite der Tür zu verwendende Dichtungselement mit einer reibungsmindernden Beschichtung versehen ist. Diese Beschichtung kann beispielsweise aus einer Beflockung aus ungerichteten Fasern bestehen. Eine solche Beflockung wird bei der Herstellung des Dichtungselementes unlösbar mit dessen Werkstoff verbunden.

Die reibungsmindernde Beschichtung kann auf der zur Auflage auf der Frontfläche des Schaltschrankes vorgesehenen Stirnfläche des Kopfsteges des Dichtungselementes angebracht sein, während auf der Frontfläche selbst ein textiles samtartiges Band befestigt ist. Durch diese Anordnung wird erreicht, daß trotz der Verminderung der Reibung beim Schließen der Tür ein hohes Maß an Dichtigkeit gegen auftreffendes Wasser oder andere Medien besteht.

Es besteht jedoch auch die Möglichkeit, daß die reibungsmindernde Beschichtung an der nach außen weisenden Seitenfläche des Kopfsteges des Dichtungselementes angebracht ist. Das Dichtungselement wirkt dann beim Schließen der Tür in der Weise, daß zunächst unter dem Einfluß der zunehmenden Reibung der Kopfsteg gegenüber dem Befestigungssteg soweit geknickt wird, bis die mit der Beschichtung versehene Kante auf der Frontfläche des Schaltschrankes aufliegt und die weitere Bewegung mit geringer Reibung erfolgen kann. Gleichzeitig erhöht sich durch die linienförmige Auflage des Dichtungselementes die Kantenpressung in der Weise, daß sich die gewünschte Dichtigkeit ergibt. In diesem Zusammenhang erweist es sich als vorteilhaft, wenn der zur Auflage auf der Frontfläche des Schaltschrankes vorgesehene Kopfsteg des Dichtungselementes eine Hohlkehle und zwei hierdurch gebildete Dichtungslippen besitzt. Diese Gestaltung ist im übrigen auch unabhängig von der Anbringung einer reibungsmindernden Beschichtung an der Seitenfläche des Kopfsteges vorteilhaft zur Verbesserung der Dichtigkeit einsetzbar. Wird die Ausführung mit reibungsmindernder Beschichtung gewählt, so kann die Dichtigkeit gegen einen äußeren Druck dadurch gesteigert werden, daß der unmittelbar an die äußere Kante bzw. Lippe angrenzende Bereich von der Beschichtung freigehalten ist.

Die vorstehend beschriebenen Formen von Dichtungselementen können mit einer elektrisch leitenden Beschichtung umhüllt sein, wobei der Befestigungssteg als Kontaktfahne zu der Tür ausgebildet ist. Hierdruch wird eine gute Dichtigkeit des Schaltschrankes auch gegen elektromagnetische Strahlung erzielt.

Wird eine Bauart von Scharnieren eingesetzt, die einen auf der Frontfläche des Schaltschrankes aufliegenden Scharnierfuß besitzen, so erweist es sich als günstig für die Dichtigkeit, wenn an der Tür nahe den Scharnieren Stützkörper für das Dichtungselement angebracht werden. Solche Stützkörper verbessern die Andruckkraft in der Weise, daß Spalte zwischen dem Dichtungselement und dem Scharnierfuß verschlossen werden.

Die Erfindung wird im folgenden anhand der in den Figuren dargestellten Ausführungsbeispiele näher erläutert.

Die Figur 1 zeigt schematisch einen Schaltschrank mit geöffneter Tür in einer Frontansicht.

In der Figur 2 ist der Schaltschrank gemäß Figur 1 in einer Seitenansicht mit geschlossener Tür dargestellt.

Die Figuren 3 und 4 zeigen unterschiedliche Ausführungen eines Dichtungselementes in Verbindung mit einem Abschnitt der Tür des Schaltschrankes.

Die Figur 5 zeigt eine reibungsmindernde Beschichtung eines Dichtungselementes.

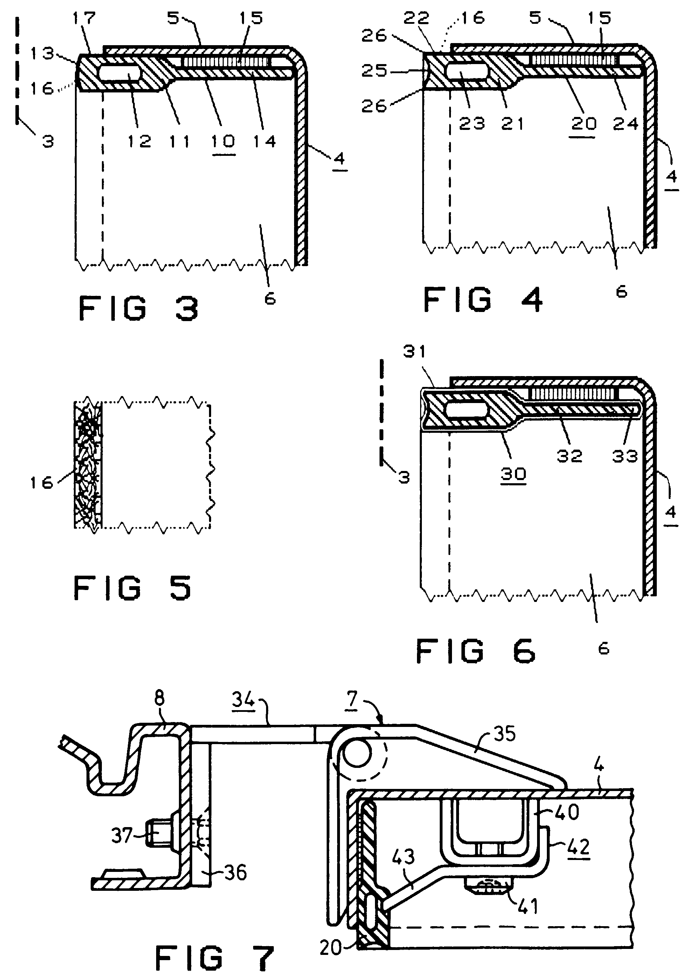

Ein Dichtungselement für erhöhte Anforderungen an die elektromagnetische Verträglichkeit ist in der Figur 6 gezeigt.

In der Figur 7 ist die Anordnung eines Dichtungselementes im Bereich einer Ecke einer Tür des Schaltschrankes dargestellt.

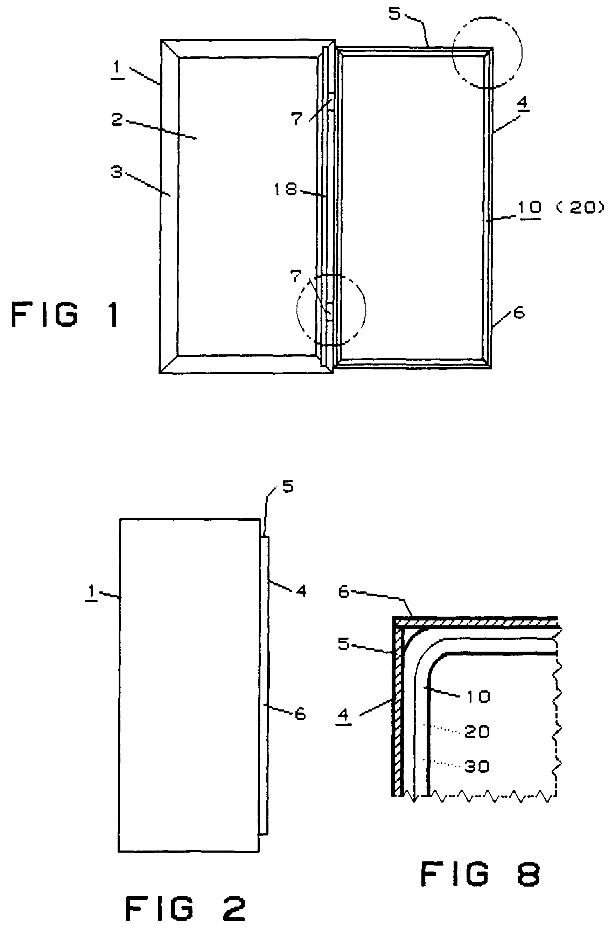

Die Figur 8 zeigt einen Stützkörper für ein Dichtungselement im Zusammenhang mit einem Scharnier und einem Teil eines Rahmens des Schaltschrankes gemäß der Figur 1.

Der in den Figuren 1 und 2 gezeigte Schaltschrank 1 weist einen Schrankkorpus 2 mit einer zur Auflage einer Tür vorgesehenen Frontfläche 3 auf, der zur Auflage einer Tür 4 vorgesehen ist. Die Tür 4 besitzt rechtwinklig abgekantete Randschenkel 5 und 6, wobei mit 5 die Randschenkel an den Schmalseiten und mit 6 die Randschenkel an den Längsseiten bezeichnet sind. Ferner sind Scharniere 7 angedeutet, um welche die Tür 4 schwenkbar ist. In der Figur 1 ist die Tür 4 um 180° geöffnet gezeigt, während sie in der Figur 2 geschlossen gezeigt ist.

Der Schrankkorpus 2 kann einen Rahmen bzw. ein Gerüst etwa entsprechend der DE-A-39 20 353 aufweisen. Ein Rahmenteil 8 ist in der Figur 7 im Schnitt gezeigt. Eine geeignete Bauart eines Scharniers ist der DE-A-40 22 079 zu entnehmen. In der Figur 1 sind lediglich zwei Scharniere 7 gezeigt. In Abhängigkeit von der Höhe und dem Gewicht der Tür 4 können auch drei oder mehr Scharniere 7 vorgesehen sein.

Mit strichpunktierten Kreisen sind in der Figur 1 Bereiche der Tür 4 gekennzeichnet, von denen Einzelheiten in den Figurn 3, 4, 5, 6 und 7 vergrößert dargestellt sind. Zunächst werden anhand der Figuren 3 und 4 zwei Ausführungsformen eines Dichtungselementes 10 bzw. 20 erläutert, das in der Figur 1 schematisch angedeutet ist.

In der Figur 3 ist in einer von den Randschenkeln 5 und 6 der Tür 4 begrenzten Ecke das Dichtungselement 10 im Schnitt gezeigt. Das Dichtungselement 10 weist einen zur Auflage auf der Frontfläche 3 des Schaltschrankes 1 (Figur 1) bestimmten Kopfsteg 11 auf, der einen Hohlraum 12 besitzt. Die Stirnfläche 13 des Dichtungselementes 10 ist ballig abgerundet. Anschließend an den Kopfsteg 11 weist das Dichtungselement 10 einen Befestigungssteg 14 mit einer gegenüber dem Kopfsteg 11 verringerten Dicke auf. Der Kopfsteg 11 liegt mit seiner Seitenfläche 17 teilweise an den Randschenkeln 5 und 6 an. An dem gegenüber der Seitenfläche 17 zurückstehenden Befestigungssteg 14 ist eine selbstklebende Haftschicht 15 angebracht. Zur Montage des Dichtungselementes 10 werden somit keine speziellen Halterungen oder Profilierungen an der Tür 4 benötigt. Vielmehr genügt es, einen bei der Herstellung des Dichtungselementes 10 auf die selbstklebende Haftschicht 15 aufgebrachte Schutzfolie abzuziehen und das Dichtungselement 10 mit seinem Befestigungssteg 14 auf die Randschenkel 5 der Tür 4 aufzulegen und anzudrücken. In bekannter Weise kann das Dichtungselement 10 aus einem gummielastischen Werkstoff bestehen. Aufgrund des Hohlraumes 12 ist der Kopfsteg 11 unter dem beim Schließen der Tür 4 auftretenden Druck verformbar und legt sich somit dicht am gesamten Umfang der Tür 4 gegen die Frontfläche 3 des Schrankkorpus 2.

Das Dichtungselement 20 gemäß der Figur 4 entspricht weitgehen dem Dichtungselement 10 gemäß der Figur 3. Dementsprechend besitzt das Dichtungselement 20 einen Kopfsteg 21 mit einer Seitenfläche 22 und einen Hohlraum 23, ferner einen Befestigungssteg 24 mit einer selbstklebenden Haftschicht 15. Unterschiedlich ist jedoch die Gestaltung der Stirnfläche des Kopfsteges 21, der mit einer Hohlkehle 25 und zwei hierdurch gebildeten Dichtungslippen 26 versehen ist.

Grundsätzlich sind beide in den Figuren 3 und 4 gezeigten Dichtungselemente 10 und 20 am gesamten Umfang der Tür 4 verwendbar. Um jedoch die besonderen Bedingungen zu erfüllen, die an der Scharnierseite der Tür bestehen, können spezielle Maßnahmen getroffen werden, um in diesem Bereich sowohl eine gute Dichtigkeit als auch einen möglichst geringeren Verschleiß der Dichtungselemente zu bewirken. Hierzu kann insbesondere gemäß der Figur 5 auf der Stirnfläche 13 des Dichtungselementes 10 eine reibungsmindernde Beschichtung 16 gemäß der Figur 5 angebracht sein. Diese wird zweckmäßig bereits bei der Herstellung des Dichtungselementes als Beflockung mit ungerichteten Fasern hergestellt. Die Beschichtung ist daher unlösbar mit dem gummielastischen Grundwerkstoff des Dichtungselementes 10 verbunden. Aufgrund der verminderten Reibung vermag das Dichtungselement 10 an der mit den Scharnieren 7 versehenen Seite des Schrankkorpus 2 (Figur 1) nach dem Aufsetzen seitwärts zu gleiten, ohne daß hierdurch der Kopfsteg 11 gegenüber dem Befestigungssteg 14 abknickt oder beschädigt wird.

Falls sich in Verbindung mit der Beschichtung 16 gemäß der Figure 5 keine ausreichende Dichtigkeit ergeben sollte, so kann der mit den Scharnieren 7 versehene Abschnitt der Frontfläche 3 mit einem Samtband 18 belegt werden, das in der Figur 1 angedeutet ist. Durch die Mitnahme der Faserelemente des Samtbandes 18 durch die Beschichtung 16 beim Schließen der Tür 4 entsteht makroskopisch eine den von außen angreifenden Medien entgegengerichtete Struktur, welche die Dichtigkeit verbessert.

Eine der Beschichtung 16 gemäß der Figur 5 entsprechende Schicht kann jedoch auch auf der nach außen weisenden Seitenfläche 17 des Kopfsteges 11 des Dichtungselementes 10 gemäß der Figur 3 oder an der Seitenfläche 22 des Kopfsteges 21 gemäß der Figur 4 angebracht werden. Die Beschichtungen werden dann in der Weise wirksam, daß die Fasern durch das aufgrund der Reibung zwischen dem Dichtungselement 10 bzw. 20 beim Schließen der Tür 4 auftretende leichte Abknicken des Kopfsteges 11 bzw. 21 an der Kante zur Auflage auf der Frontfläche 3 gelangen. Es ergibt sich dennoch eine gute Dichtigkeit, weil das Dichtungselement auf der Frontfläche 3 mit einer schmalen Kante aufliegt. Dieser Vorgang tritt insbesondere bei dem mit Dichtungslippen 26 versehenen Dichtungselement 20 ausgeprägt auf und kann dadurch noch verbessert werden, daß der unmittelbare Kantenbereich des Dichtungselementes von der Beschichtung freigehalten ist.

Für hohe Anforderungen an die elektromagnetische Verträglichkeit (EMV) der Schaltschränke eignet sich das Dichtungselement 30 gemäß der Figur 6. Das Dichtungselement 30 besitzt eine dem Dichtungselement 20 gemäß der Figur 4 ähnliche Gestalt, ist jedoch völlig von einer elektrisch leitfähigen Beschichtung 31 umhüllt. Diese kann z. B. durch eine leitfähige Randschicht des gummielastischen Werkstoffes oder besonders wirksam durch ein feines Metallgewebe gebildet sein. Der Befestigungssteg 32 ist als Kontaktfahne 33 ausgebildet, die an der Tür 4 anliegt. Es empfiehlt sich, die Frontfläche 3 und die Innenseite der Tür 4 metallisch blank zu gestalten, z. B. durch Vernickelung o. ä.. Durch ein Dichtungselement 30 wird der Spalt zwischen der Frontfläche 3 und der Tür 4 elektrisch wirksam verschlossen, wodurch die Dichtigkeit gegen einen Durchtritt elektromagnetischer Stellung verbessert wird.

Wie bereits erwähnt, eignen sich die beschriebenen Dichtungselemente aufgrund ihrer guten Anpassungsfähigkeit auch für den Bereich der Scharniere 7 (Figur 1). Eine lückenlose Anlage der Dichtungselemente an diesen Stellen ist insbesondere dann vorteilhaft, wenn auf der Frontfläche 3 des Schrankkorpus 2 zu montierende ortsfeste Scharnierteile vorgesehen sind, wie sie beispielsweise in der erwähnten DE-A-40 22 079 beschrieben sind. Zur Veranschaulichung der sich dort ergebenden Lage der Teile ist in der Figur 8 ein Rahmenteil 8 des Schrankkorpus 2 mit einem ortsfesten Scharnierarm 34 und einem bewegbaren Scharnierarm 35 gezeigt. Der ortsfeste Scharnierarm 34 ist mit seinem Fußteil 31 durch eine Schraube 37 an dem Rahmenteil 8 des Schrankkorpus 2 befestigt. Die mit einem Dichtungselement 20 gemäß der Figur 4 versehene Tür 4 ist in einer um 90° geöffneten Stellung dargesellt. Der bewegbare Scharnierarm 35 ist an der Tür 4 mittels eines Klemmbügels 40 und einer Schraube 41 befestigt. Zugleich ist mittels der Schraube 41 ein Stützkörper 42 befestigt, der gegen den Kopfsteg 21 stoßende Stützarme 43 besitzt. Auf diese Weise wird ein Ausweichen des Kopfsteges 21 beim Schließen der Tür 4 und dem hierbei erfolgenden Auftreffen des Kopfsteges 21 auf dem Fußteil 36 des ortsfesten Scharnierarmes 34 vermieden. Vielmehr ergibt sich eine erhöhte Andruckkraft mit einer entsprechend höheren Dichtigkeit.

In der Figur 8 ist ferner die Anbringung der Dichtungselemente 10 bzw. 20 im Bereich einer Ecke der Tür 4 veranschaulicht. Wie man erkennt, kann das Dichtungselement 10 bzw. 20 im Bogen ohne Unterbrechung von dem abgekanteten Schenkel 5 auf den Schenkel 6 übergeleitet werden. Für die Dichtigkeit ist es ohne Bedeutung, daß durch den bogenförmigen Verlauf ein kleiner Eckbereich der Tür 4 nicht von dem Dichtungselement ausgefüllt ist.

## Patentansprüche

1. Schaltschrank (1) mit einer durch Rahmenteile (8) gebildeten Frontfläche (3) zur Auflage einer mit in Richtung auf die Frontfläche (3) abgekanteten Randschenkeln (5, 6) versehenen Tür (4), wobei an der Tür (4) zur Abdichtung im geschlossenen Zustand Dichtungselemente (10; 20) aus gummielastischem Material angebracht sind,
**dadurch gekennzeichnet**, daß die Dichtungselemente (10; 20) einen zur Auflage auf der Frontfläche (3) bestimmten hohl ausgebildeten Kopfsteg (11; 21) und anschließend an den Kopfsteg (11; 21) einen zur Anbringung an einem der Randschenkel (5, 6) der Tür (4) mittels einer selbstklebenden Haftschicht (15) bestimmten Befestigungssteg (14) besitzen, wobei der Kopfsteg (11, 21) mit einer Seitenfläche (17) teilweise an den Randschenkeln (5, 6) anliegt und wobei der Befestigungssteg (14) gegenüber der einen Seitenfläche (17; 22) des Kopfsteges (11; 21) um etwa die Dicke der Haftschicht (15) zurückgesetzt angeordnet ist.

2. Schaltschrank nach Anspruch 1,
**dadurch gekennzeichnet**, daß zur Verminderung der Reibung beim Schließen und Öffnen der Tür (4) wenigstens das an der Scharnierseite der Tür (4) zu verwendende Dichtungselement (10; 20) mit einer reibungsmindernden Beschichtung (16) versehen ist.

3. Schaltschrank nach Anspruch 2,
**dadurch gekennzeichnet**, daß die reibungsmindernde Beschichtung (16) aus einer Beflockung aus ungerichteten Fasern besteht.

4. Schaltschrank nach Anspruch 3,
**dadurch gekennzeichnet**, daß die reibungsmindernde Beschichtung (16) aus ungerichteten Fasern auf der zur Auflage auf der Frontfläche (3) des Schaltschrankes (1) vorgesehenen Stirnfläche (13) des Kopfsteges (11) des Dichtungselementes (10) angebracht ist und daß auf der Frontfläche (3) ein textiles samtartiges Band (18) befestigt ist.

5. Schaltschrank nach Anspruch 3,
**dadurch gekennzeichnet**, daß die reibungsmindernde Beschichtung (16) an der nach außen weisenden Seitenfläche (17; 22) des Kopfsteges (11; 21) des Dichtungselementes (10; 20) angebracht ist.

6. Schaltschrank nach einem der vorangehenden Ansprüche,
**dadurch gekennzeichnet**, daß der zur Auflage auf der Frontfläche (3) des Schaltschrankes (1) vorgesehene Kopfsteg (21) des Dichtungselementes (20) eine Hohlkehle (25) und zwei hierdurch gebildete Dichtungslippen (26) besitzt.

7. Schaltschrank nach Anspruch 5 oder 6,
**dadurch gekennzeichnet**, daß der unmittelbar an die äußere Kante bzw. Lippe (26) des Dichtungselementes (10; 20) angrenzende Bereich von der reibungsmindernden Beschichtung (16) freigehalten ist.

8. Schaltschrank nach einem der vorangehenden Ansprüche,
**dadurch gekennzeichnet**, daß das Dichtungselement (30) von einer elektrisch leitfähigen Beschichtung (31) umhüllt und daß der Befestigungssteg (32) als Kontaktfahne (33) zu der Tür (4) ausgebildet ist.

9. Schaltschrank nach einem der vorangehenden Ansprüche,
**dadurch gekennzeichnet**, daß an der Tür (4) nahe den Scharnieren (7) Stützkörper (42) mit Stützarmen (43) für das Dichtungselement (20) angebracht sind.

## Claims

1. Switchgear cabinet (1) having a front surface (3) which is formed by frame parts (8) and serves to bear a door (4) provided with edge limbs (5, 6) which are folded in the direction of the front surface (3), sealing elements (10; 20) made from gum elastic material being attached to the door (4) to seal in the closed state, characterized in that the sealing elements (10; 20) have a head web (11; 21) of hollow construction intended for bearing on the front surface (3) and, adjoining the head web (11; 21), a fastening web (14) intended for attachment to one of the edge limbs (5, 6) of the door (4) by means of a self-adhesive layer (15), the head web (11; 21) bearing with a side face (17) partly against the edge limbs (5, 6), and the fastening web (14) being arranged set back with respect to one side face (17; 22) of the head web (11; 21) by approximately the thickness of the adhesive layer (15).

2. Switchgear cabinet according to Claim 1, characterized in that for the purpose of reducing friction during closing and opening of the door (4) at least that sealing element (10; 20) to be used on the hinge side of the door (4) is provided with a friction-reducing coating (16).

3. Switchgear cabinet according to Claim 2, characterized in that the friction-reducing coating (16) comprises a covering of non-directional fibres.

4. Switchgear cabinet according to Claim 3, characterized in that the friction-reducing coating (16) made from non-directional fibres is attached to the end face (13), provided for bearing on the front surface (3) of the switchgear cabinet (1), of the head web (11) of the sealing element (10), and in that a textile velvet-like tape (18) is fastened to the front surface (3).

5. Switchgear cabinet according to Claim 3, characterized in that the friction-reducing coating (16) is attached to the side face (17; 22), which points outwards, of the head web (11; 21) of the sealing element (10; 20).

6. Switchgear cabinet according to one of the preceding claims, characterized in that the head web (21), provided for bearing on the front surface (3) of the switchgear cabinet (1), of the sealing element (20) has a groove (25) and two sealing lips (26) formed thereby.

7. Switchgear cabinet according to Claim 5 or 6, characterized in that the region bordering immediately on the outer edge or lip (26) of the sealing element (10; 20) is kept free of the friction-reducing coating (16).

8. Switchgear cabinet according to one of the preceding claims, characterized in that the sealing element (30) is covered by an electrically conductive coating (31), and in that the fastening web (32) is constructed as a contact lug (33) for the door (4).

9. Switchgear cabinet according to one of the preceding claims, characterized in that support members (42) with support arms (43) for the sealing element (20) are attached to the door (4) near the hinges (7).

## Revendications

1. Armoire (1) de distribution comportant une surface (3) frontale formée par des pièces (8) de cadre et destinée à l'appui d'une porte (4) munie de branches (5, 6) de bord chanfreinées en direction de la surface frontale (3), des éléments (10 ; 20) d'étanchéité en un matériau ayant l'élasticité du caoutchouc étant mis en place sur la porte (4) pour assurer l'étanchéité à l'état fermé,
caractérisée en ce que les éléments (10 ; 20) d'étanchéité comprennent une barrette (11 ; 21) de tête creuse et destinée à l'appui sur la surface frontale (3) et, à la suite de la barrette (11 ; 21) de tête, une barrette (14) de fixation destinée à la mise en place sur l'une des branches (5, 6) de bord de la porte (4) au moyen d'une couche (15) adhésive autocollante, la barrette (11, 21) de tête s'appliquant en partie aux branches (5, 6) de bord par une surface latérale (17) et la barrette (14) de fixation étant disposée en retrait d'environ l'épaisseur de la couche (15) adhésive par rapport à l'une des surfaces latérales (17 ; 22) de la barrette (11 ; 21) de tête.

2. Armoire de distribution suivant la revendication 1,
caractérisée en ce que au moins l'élément (10 ; 20) d'étanchéité à utiliser du côté charnière de la porte (4) est pourvu d'un revêtement (16) diminuant la friction lors de la fermeture et de l'ouverture de la porte (4).

3. Armoire de distribution suivant la revendication 2,
caractérisée en ce que le revêtement (16) diminuant la friction est constitué d'un flocage de fibres dirigées au hasard.

4. Armoire de distribution suivant la revendication 3,
caractérisée en ce que le revêtement (16) diminuant la friction en fibres non dirigées est mis en place sur la surface frontale (13) de la barrette (11) de tête de l'élément (10) d'étanchéité, qui est prévue pour l'appui sur la surface frontale (3) de l'armoire (1) de distribution et une bande (18) textile veloutée est fixée à la surface frontale (3).

5. Armoire de distribution suivant la revendication 3,
caractérisée en ce que le revêtement (16) diminuant la friction est mis en place sur la surface latérale (17 22) de la barrette (11 ; 21) de tête de l'élément (10 20) d'étanchéité, qui est dirigée vers l'extérieur.

6. Armoire de distribution suivant l'une des revendications précédentes, caractérisée en ce que la barrette (21) de tête de l'élément (20) d'étanchéité, qui est prévue pour l'appui sur la surface frontale (3) de l'armoire (1) de distribution comprend une goulotte (25) et deux lèvres (26) d'étanchéité formées par celle-ci.

7. Armoire de distribution suivant la revendication 5 ou 6,
caractérisée en ce que la zone directement adjacente au bord ou à la lèvre (26) extérieure de l'élément (10 ; 20) d'étanchéité est exempte du revêtement (16) diminuant la friction.

8. Armoire de distribution suivant l'une des revendications précédentes, caractérisée en ce que l'élément (30) d'étanchéité est enveloppé d'un revêtement (31) pouvant conduire l'électricité et la barrette (32) de fixation est sous forme d'une queue (33) de contact vers la porte (4).

9. Armoire de distribution suivant l'une des revendications précédentes, caractérisée en ce que des corps (42) d'appui comportant des bras (43) d'appui pour l'élément (20) d'étanchéité sont mis en place sur la porte (4) près des charnières (7).
